# EUROPÄISCHE PATENTSCHRIFT

(11) **EP 0 524 166 B1**
(45) Veröffentlichungstag und Bekanntmachung des Hinweises auf die Patenterteilung: **12.10.1994**
(21) Anmeldenummer: 90905434.8
(22) Anmeldetag: 09.04.1990
(51) Int. Cl.: G01N 27/02, G01R 27/26

(54) **VERFAHREN UND VORRICHTUNG ZUR BESTIMMUNG DER ELEKTRISCHEN LEITFÄHIGKEIT EINES PROBENKÖRPERS AUS SUPRALEITFÄHIGEM MATERIAL**
PROCESS AND DEVICE FOR DETERMINING THE ELECTRICAL CONDUCTIVITY OF A TEST SPECIMEN MADE OF SUPERCONDUCTING MATERIAL
PROCEDE ET DISPOSITIF POUR DETERMINER LA CONDUCTIVITE ELECTRIQUE D'UNE EPROUVETTE CONSTITUEE D'UN MATERIAU SUPRACONDUCTEUR

(43) Veröffentlichungstag der Anmeldung: 27.01.1993
(73) Patentinhaber: SIEMENS AKTIENGESELLSCHAFT, 80333 München (DE)
(72) Erfinder: CHALOUPKA, Heinz, D-4630 Bochum (DE); LÖHE, Michael, D-5090 Leverkusen 1 (DE); PEINIGER, Michael, D-5828 Ennepetal (DE)
(86) Internationale Anmeldenummer: DE9000279
(87) Internationale Veröffentlichungsnummer: WO9115755

(56) Entgegenhaltungen:
- EP-A- 0 337 253
- JOURNAL OF PHYSICS E.SCIENTIFIC INSTRUMENTS, Band 12, Nr. 6, Juni 1979, GB; I.M.CHAPNIK: "Sensitive detection of superconductivity by change in penetration depth of electromagnetic fields in thin metal foils", Seiten 469-470
- JOURNAL OF PHYSICS E.SCIENTIFIC INSTRUMENTS, Band 16, Nr. 7, Juli 1983, The Institute of Physics, Dorking, GB; E.J.VEENENDAAL et al.: "A frequency-modulated Q-meter for very low-temperature NMR experiments", Seiten 649-653
- ELECTRONICS & WIRELESS WORLD, Band 93, Nr. 1608, Oktober 1986, Sutton, Surrey, GB; E.MCKENNY JR.: "Novel Q meter", Seiten 38-39

## Beschreibung

Die Erfindung betrifft ein Verfahren und eine Vorrichtung zur Bestimmung der elektrischen Leitfähigkeit eines Probenkörpers aus supraleitfähigem Material.

Leitfähigkeitsmessungen an supraleitfähigen Materialien sind, neben weiteren Meßverfahren, z. B. Meßverfahren unter Ausnutzung des Meißner-Ochsenfeld-Effektes, von großer Bedeutung zur Bestimmung der Sprungtemperatur und weiterer Charakteristika der supraleitfähigen Materialien, und seit Entdeckung der inzwischen als Hochtemperatursupraleiter bekannten Keramiken gleichermaßen wichtig bei der Suche nach neuen, supraleitfähigen Zusammensetzungen und bei der technischen Anwendung bereits bekannter Hochtemperatursupraleiter zu Kontroll- und Prüfzwecken.

Eine besondere Rolle kommt dabei den "kontaktfreien" Meßverfahren zu, also denjenigen Meßverfahren, die keines unmittelbaren elektrischen Anschlusses der zu untersuchenden Probenkörper an ein elektronisches Netzwerk irgendwelcher Art bedürfen. Ein derartiges Meßverfahren ist das Wirbelstrom-Meßverfahren, bei dem der zu untersuchende Probenkörper in das Magnetfeld einer Spulenanordnung eingebracht wird, die mit einem hochfrequenten Wechselstrom beaufschlagt ist. Ein Verfahren sowie eine Vorrichtung für Wirbelstrommessungen an supraleitfähigen Materialien werden vorgestellt in der EP-A-0 337 253. Die Spulenanordnung ist dabei Bestandteil eines Schwingkreises, der das frequenzbestimmende Element einer Oszillatorschaltung ist. Meßgröße ist die Resonanzfrequenz des Schwingkreises, die durch einen im Magnetfeld der Spulenanordnung befindlichen Probenkörper beeinflußt wird. Dabei ist wesentlich, daß durch das Magnetfeld in dem Probenkörper Wirbelströme induziert werden, die ihrerseits Induktionswirkungen auf die Spulenanordnung ausüben und somit deren Induktivität verändern. Aus der Änderung der Induktivität resultiert unmittelbar eine Änderung der Resonanzfrequenz des Schwingkreises, und somit ist aus der Verschiebung der Resonanzfrequenz, falls der Spulenanordnung ein Probenkörper genähert wird, ein Rückschluß auf die elektrischen Eigenschaften des Probenkörpers möglich. Der Betrag der Änderung der Resonanzfrequenz ist natürlich nicht nur von der elektrischen Leitfähigkeit des Probenkörpers, sondern auch von seiner Gestalt, der Gestalt der Spulenanordnung und der räumlichen Anordnung von Spulenanordnung und Probenkörper abhängig. Die mit einer solchen Wirbelstrommessung zu gewinnenden Informationen sind in erster Linie qualitativer Natur, jedoch sind durch Festlegung der Form und Anordnung von Probenkörper und Spulenanordnung sowie Vergleichsmessungen mit Probenkörpern aus Materialien mit bekannten Eigenschaften unter Umständen auch quantitative Messungen denkbar.

Die Anwendung der Methoden gemäß der EP-A-0 337 253 zu Präzisionsmessungen wird dadurch eingeschränkt, daß die zu messende Größe nur noch schwach von dem eigentlich interessierenden Parameter der elektrischen Leitfähigkeit des zu untersuchenden Materials, abhängt, wenn die Leitfähigkeit sehr hoch wächst. Das Magnetfeld der Spulenanordnung induziert in dem Probenkörper hochfrequente Wirbelströme gemäß einer Stromverteilung, die, sofern die Leitfähigkeit hinreichend hoch ist, im wesentlichen nur noch von der Geometrie von Spulenanordnung und zugeordnetem Probenkörper abhängt; die Induktivität der durch den Probenkörper beeinflußten Spulenanordnung nähert sich asymptotisch einem konstanten Wert, wenn die Leitfähigkeit des Probenkörpers über alle Grenzen wächst, wie dies beim Einsetzen der Supraleitung der Fall ist. Wird die Temperatur des Probenkörpers unter die dem Material des Probenkörpers entsprechende Sprungtemperatur abgesenkt, so ändert sich die Induktivität lediglich in dem Maße, indem sich die Stromverteilung in dem Probenkörper z. B. aufgrund des Entstehens lokal begrenzter supraleitender Bezirke verändert. Die Empfindlichkeit der Meßmethode ist im Übergangsbereich zwischen supraleitfähiger und nicht-supraleitfähiger Phase des Materials daher recht gering; sie mag aufgrund ihrer Einfachheit für qualitative, nur geringe Präzision erfordernde Messungen verwendbar sein, zur Lieferung quantitativer Aussagen über die Leitfähigkeit eines supraleitfähigen Materials in der Nähe der Sprungtemperatur ist sie nicht geeignet.

Mit der vorliegenden Erfindung soll dementsprechend ein Weg zur Messung der elektrischen Leitfähigkeit eines supraleitfähigen Materials angegeben werden, wobei die Bestimmung der elektrischen Leitfähigkeit im Temperaturbereich des Übergangs zwischen nicht-supraleitfähiger und supraleitfähiger Phase mit hoher Empfindlichkeit und entsprechend hoher Präzision möglich ist und alle Vorzüge der Wirbelstrom-Meßmethode gewahrt bleiben sollen.

Diese Aufgabe wird erfindungsgemäß gelöst durch ein Verfahren zur Bestimmung der elektrischen Leitfähigkeit eines Probenkörpers aus supraleitfähigem Material, unter Benutzung eines Parallelschwingkreises aus einer Spulenanordnung mit einer Induktivität und einer Kondensatoranordnung mit einer Kapazität, wobei der Parallelschwingkreis eine durch Variation der Induktivität und/oder Variation der Kapazität abstimmbare Resonanzfrequenz sowie einen Resonanzwiderstand aufweist, unter Einbeziehung folgender Schritte:
a) Annähern des Probenkörpers an die Spulenanordnung, so daß der Probenkörper von einem in der Spulenanordnung erzeugten Magnetfeld durchsetzbar ist;
b) Ermittlung der elektrischen Leitfähigkeit durch Messung der Resonanzfrequenz;
   **gekennzeichnet durch**
c) Messung des Resonanzwiderstandes zusätzlich zur Messung der Resonanzfrequenz sowie Abstimmung der Resonanzfrequenz derart, daß der Resonanzwiderstand gleich einem vorgebbaren Sollwert wird;
d) Ermittlung der elektrischen Leitfähigkeit unter der Bedingung, daß der Resonanzwiderstand gleich dem Sollwert ist.

Ein wesentlicher Aspekt der Erfindung ist die Messung eines Parameters, der empfindlich von der elektrischen Leitfähigkeit des zu untersuchenden Materials abhängt, mit möglichst hoher Genauigkeit. Die Erfindung geht davon aus, daß durch die Einführung eines elektrisch leitfähigen Probenkörpers in das Magnetfeld einer Spulenanordnung nicht nur die Induktivität dieser Spulenanordnung verändert wird, sondern daß aufgrund der in dem Probenkörper auftretenden Wirbelstromverluste zu der Induktivität ein Ohmscher Widerstand hinzutritt. Die Anordnung aus Spule und Probenkörper kann modelliert werden als Transformator mit einer Primärwicklung, die durch die Spule gegeben ist, und einer Sekundärwicklung mit angeschlossenem Ohmschem Widerstand, wobei Sekundärwicklung und Ohmscher Widerstand den Probenkörper modellieren. Das Transformatorbild stellt insoweit eine Vereinfachung dar, als der Probenkörper nicht aus isolierten Wicklungen besteht, sondern vielmehr eine kontinuierliche Stromverteilung aufweist, und darüber hinaus Sekundärwicklung und ohmscher Widerstand keine separaten Elemente sind. Zum Zwecke der Beschreibung der Impedanz der Spule, in die der Probenkörper eingebracht ist, ist dieses Modell jedoch einwandfrei anwendbar. Sofern die Leitfähigkeit des Probenkörpers ausreichend hoch ist, kann die Spule, in deren Magnetfeld der Probenkörper angeordnet ist, beschrieben werden als Reihenschaltung einer verlustfreien Spule und eines ohmschen Widerstandes. Die Induktivität dieser verlustfreien Spule ist dabei gegenüber der Induktivität der eigentlichen Spule mit entferntem Probenkörper reduziert, wobei die Reduktion der Induktivität im wesentlichen bedingt ist durch die Geometrie der Anordnung; der mit der verlustfreien Spule in Reihe liegende ohmsche Widerstand ist gleich der Summe aus dem Verlustwiderstand und einem Term, der dem Verlustwiderstand umkekehrt proportional ist. Die entsprechende Proportionalitätskonstante enthält dabei neben der Induktivität der eigentlichen Spule Faktoren, die sich aus der Geometrie der Anordnung ergeben. Der durch den Probenkörper bedingte Widerstand ist mithin eine Größe, die auch dann noch von der Leitfähigkeit des Probenkörpers abhängt, wenn diese sehr groß wird; für eine über alle Grenzen hinaus wachsende Leitfähigkeit - beim Eintritt der Supraleitfähigkeit - wird er allerdings Null, und es ist zur Bestimmung der elektrischen Leitfähigkeit des Probenkörpers über die Messung des Verlustwiderstandes ein Meßverfahren erforderlich, mit dem diese sehr kleine Größe mit hinreichender Präzision gemessen werden kann.

Die Transformation des durch den Probenkörper bedingten kleinen Verlustwiderstandes der Spule in eine einfach und sicher meßbare Größe erfolgt gemäß der Erfindung derart, daß der Reihenschaltung aus Spule und Verlustwiderstand eine Kondensatoranordnung unter Bildung eines verlustbehafteten Parallelschwingkreises parallel geschaltet wird. Durch den Verlustwiderstand der Spule wird einerseits die Resonanzfrequenz und andererseits der Resonanzwiderstand des Parallelschwingkreises, der elektrische Widerstand, den der Parallelschwingkreis bei Beaufschlagung mit einer Wechselspannung bei Resonanzfrequenz darstellt, beeinflußt, Der Resonanzwiderstand des verlustbehafteten Parallelschwingkreises ist nicht, wie im Idealfall, unendlich hoch, sondern er hat einen Wert gleich der Summe aus Verlustwiderstand und einem Term, der dem Verlustwiderstand umgekehrt proportional ist. Durch geeignete Wahl der Induktivität der Spule und der Kapazität der Kondensatoranordnung kann erreicht werden, daß relativ kleine Werte für den Verlustwiderstand in gut meßbare Werte für den Resonanzwiderstand transformiert werden.

Ein weiteres Element der Erfindung ist die Anwendung eines besonders genauen Meßverfahrens für den Resonanzwiderstand, das der direkten Messung durch Beaufschlagung des Parallelschwingkreises mit einer Wechselspannung mit Resonanzfrequenz und Bestimmung des in den Schwingkreis fließenden Stromes überlegen ist. Ausgangspunkt dazu ist, daß der Resonanzwiderstand des Kreises nicht nur von dem Verlustwiderstand, sondern auch von der Induktivität und der Kapazität abhängt. Durch extern bewirkte Abstimmung der Kapazität und/oder der Induktivität wird der Resonanzwiderstand des Kreises auf einem vorbestimmten Wert gehalten; die durch Variation der Kapazität und/oder der Induktivität entstehenden Änderungen der Resonanzfrequenz werden, da sie mit extrem hohen Genauigkeiten meßbar sind, als Meßgrößen für die elektrische Leitfähigkeit des Probenkörpers benutzt.

Zur Messung von Resonanzfrequenz und Resonanzwiderstand des Parallelschwingkreises im Rahmen des Verfahrens nach der Erfindung wird der Parallelschwingkreis mit einem Wechselstromsignal aus einem Generator beaufschlagt. Zur Bestimmung der Resonanzfrequenz wird die Frequenz des Wechselstromsignals beispielsweise derart eingestellt, daß die Stromamplitude des dem Parallelschwingkreis zugeführten Wechselstromes minimal wird unter Beibehaltung einer festen Spannungsamplitude der über dem Parallelschwingkreis liegenden Wechselspannung, und anschließend wird der Resonanzwiderstand bestimmt als Quotient aus Spannungsamplitude und Stromamplitude.
Eine besonders günstige Weiterbildung des erfindungsgemäßen Verfahrens ist dadurch gekennzeichnet, daß der Parallelschwingkreis Bestandteil eines Oszillators ist, in dem zumindest zur Messung der Resonanzfrequenz eine elektronische Schwingung erzeugt wird. Die in dem Parallelschwingkreis erzeugte elektronische Schwingung hat als Frequenz genau die Resonanzfrequenz, die damit ohne weiteres und unmittelbar mit entsprechenden Frequenzmeßeinrichtungen bestimmbar ist.

Zur Bestimmung des Resonanzwiderstandes kann ausgenutzt werden, daß im Rahmen eines Oszillators das Signal über dem frequenzbestimmenden Parallelkreis in seiner Größe begrenzt wird; eine Oszillatorschaltung kann immer verstanden werden als negativer Ohmscher Widerstand, der mit dem positiven Resonanzwiderstand des frequenzbestimmenden Schwingkreises verschaltet ist und diesen kompensiert. Zur Anfachung der Schwingung muß der Betrag des negativen Widerstandes so gewählt werden, daß sich aus der Zusammenschaltung von negativem Widerstand und Resonanzwiderstand ein negativer Widerstand ergibt. Durch das stets vorhandene Rauschen des Oszillators wird die Schwingung angefacht, und die Amplitude der Schwingung würde, sofern es keine begrenzenden Mittel gäbe, über alle Grenzen hinaus wachsen. Eine Begrenzung der Amplitude der Schwingung erfolgt im einfachsten Fall dadurch, daß in dem Oszillator irgendeine Übersteuerung auftritt. Dies resultiert in einer Veränderung des negativen Widerstandes, der sich mit wachsender Amplitude der Schwingung dem Resonanzwiderstand angleicht, womit ein weiterer Anstieg der Amplitude unterbunden wird. Eine günstige Möglichkeit für eine Begrenzung der Schwingung in dem Parallelschwingkreis ist beispielsweise das Stabilisieren der Spannungsamplitude auf einen vorgegebenen Wert; zur Messung des Resonanzwiderstandes muß dann lediglich die Stromamplitude des in den Parallelschwingkreis fließenden Stromes bestimmt werden. Alternativ kann die Stromamplitude des dem Parallelschwingkreis zugeführten Stromes auf einen vorgegebenen Wert stabilisiert werden, und der Resonanzwiderstand ergibt sich aus der Spannungsamplitude. Dies ist eine besonders günstige Weiterbildung, da mit der Spannungsamplitude unmittelbar eine dem Resonanzwiderstand direkt proportionale Größe gemessen wird.

Im Rahmen aller Ausgestaltungen des Verfahrens nach der Erfindung wird die Resonanzfrequenz des Parallelschwingkreises in der Größenordnung einiger MHz, namentlich etwa in dem Bereich zwischen 1 MHz und 20 MHz, vorzugsweise etwa in dem Bereich zwischen 2 MHz und 10 MHz, gewählt. Die Wahl der Resonanzfrequenz ist in erster Linie bestimmt durch die günstig realisierbaren Größen der Induktivität und der Kapazität, wobei die Größe der Induktivität in erster Linie die bestimmende Größe ist. Spulen mit typischen Abmessungen von einigen cm, die ohne Verwendung ferromagnetischer Kerne gewickelt sind, weisen Induktivitäten der Größenordnung von etwa 0,1 µH bis etwa 1 µH auf; sie sind für Schwingkreise mit Resonanzfrequenzen der angegebenen Größenordnung am besten geeignet.

Die Vorzüge des Verfahrens nach der Erfindung werden in besonderer Weise ausgenutzt bei der Anwendung zur Messung sehr kleiner elektrischer Leitfähigkeiten, wie sie insbesondere dann auftreten, wenn ein supraleitfähiges Material auf eine Temperatur unterhalb seiner Sprungtemperatur abgekühlt wird, beim Übergang aus der nicht-supraleitenden Phase in die Supraleitende Phase. Vor allem Materialien aus den bekannten oxidischen Hochtemperatursupraleitern weisen stetig verlaufende Übergänge aus der normalleitenden Phase in die supraleitende Phase auf, die in Anbetracht der hohen Empfindlichkeit auf hohe elektrische Leitfähigkeiten mit dem erfindungsgemäßen Verfahren besonders gut ausgemessen werden können. Hierzu wird die gemäß der Erfindung bestimmte Resonanzfrequenz in Abhängigkeit von der Temperatur des Probenkörpers aus supraleitfähigem Material im Bereich der Sprungtemperatur bestimmt; das Verhalten der elektrischen Leitfähigkeit des Probenkörpers in der unmittelbaren Umgebung der Sprungtemperatur kann durch das Studium dieser Abhängigkeit besonders leicht ermittelt werden.

Gegenstand der Erfindung ist auch eine Vorrichtung zur Bestimmung der elektrischen Leitfähigkeit eines Probenkörpers aus supraleitfähigem Material, die folgende Bestandteile aufweist:
a) Eine Spulenanordnung mit einer Induktivität, durch welche Spulenanordnung ein Magnetfeld erzeugbar ist, in das der Probenkörper einbringbar ist;
b) mindestens eine Kondensatoranordnung mit einer Kapazität, welche Kondensatoranordnung mit der Spulenanordnung zu einem Parallelschwingkreis mit einer Resonanzfrequenz und einem Resonanzwiderstand verschaltet ist, welche Resonanzfrequenz durch Variation der Induktivität und/oder Variation der Kapazität abstimmbar ist;
c) einen Generator, durch den in dem Parallelschwingkreis eine elektronische Schwingung mit der Resonanzfrequenz erregbar ist, welche Schwingung charakterisiert ist durch eine über dem Parallelschwingkreis liegende Wechselspannung mit einer Spannungsamplitude und einen dem Parallelschwingkreis zugeführten Wechselstrom mit einer Stromamplitude;
d) eine Frequenzmeßeinrichtung, mit der die Resonanzfrequenz meßbar ist;
   erfindungsgemäß gekennzeichnet durch
e) eine Regeleinrichtung, mit der Resonanzwiderstand meßbar und die Resonanzfrequenz abstimmbar sowie die Resonanzfrequenz mit dem Resonanzwiderstand und einem vorgebbaren Sollwert für den Resonanzwiderstand derart korrelierbar ist, daß bei einer Abweichung des Resonanzwiderstandes von dem Sollwert durch Abstimmung der Resonanzfrequenz eine Übereinstimmung der Resonanzfequenz mit dem Sollwert erzielbar ist.

Eine derartige Vorrichtung ist für die Ausführung des erfindungsgemäßen Verfahrens besonders geeignet. Die Abstimmung der Resonanzfrequenz - hierunter wird nicht die durch das Einbringen des Probenkörpers bewirkte Änderung der Resonanzfrequenz verstanden - erfolgt durch mechanische oder elektronische Veränderung der Kapazität eines einstellbaren Kondensators, durch mechanische oder anderweitige Veränderung der Induktivität einer Spule, oder durch Kombinationen solcher Handlungen. Bauformen für Spulen und Kondensatoren, die solches zulassen, sind in großer Zahl bekannt und in der Anwendung dem Fachmann geläufig. Die eventuell erforderliche Regelung eines Wechselstromsignals, mit dem der Parallelschwingkreis zu beaufschlagen ist, wurde bereits erwähnt und ist auch im Rahmen der erfindungsgemäßen Vorrichtung vorzunehmen.

Ein wesentliches Element der Vorrichtung nach der Erfindung ist eine Regeleinrichtung, mit der die Resonanzfrequenz des Parallelschwingkreises weitgehend automatisch derart abzustimmen ist, daß der Resonanzwiderstand des Parallelschwingkreises gleich dem vorgegebenen Sollwert wird. Ein solcher Regler besteht im einfachsten Fall aus seiner Schaltung, die eine Ausgangsgröße liefert, die proportional dem Integral über den zeitlichen Verlauf der Eingangsgröße ist; es kann auch ein geeignet dimensionierter PI-Regler Verwendung finden. Als Eingangsgröße dient die Differenz aus dem Meßwert für den Resonanzwiderstand und dem Sollwert für den Resonanzwiderstand; die Ausgangsgröße ist z. B. eine Regelspannung zur Einstellung der frequenzbestimmenden Elemente des Parallelschwingkreises. Als frequenzbestimmendes Element besonders geeignet ist beispielsweise eine Anordnung aus zwei Kapazitätsdioden.

Eine vorteilhafte Weiterbildung der Vorrichtung gemäß der Erfindung ist, unbeschadet anderweitiger Weiterbildungen, dadurch gekennzeichnet, daß der Generator mit dem Parallelschwingkreis zu einem Oszillator verschaltet ist, wobei der Parallelschwingkreis das frequenzbestimmende Element des Oszillators ist. Eine derartige Vorrichtung ist im wesentlichen automatisch betreibbar; die Durchführung der Messung der elektrischen Leitfähigkeit beschränkt sich auf die Messung der Resonanzfrequenz, und weitere Einstellungen sind nicht erforderlich.

Im Rahmen eines Oszillators wird einem frequenzbestimmenden Parallelschwingkreis stets ein negativer ohmscher Widerstand parallel gelegt, der den Resonanzwiderstand, einen positiven ohmschen Widerstand, kompensiert - dies wurde bereits ausgeführt. Eine besonders vorteilhafte Weiterbildung der Vorrichtung nach der Erfindung wird erreicht, indem der minimale Betrag des negativen Widerstandes des Oszillators einstellbar ist. Die Betriebsbedingungen des Oszillators können auf diese Weise den durch die zu vermessenden Probenkörper und die Geometrie der Spulenanordnung gegebenen Verhältnissen optimal angepaßt werden, und es sind weitere Steigerungen der Empfindlichkeit der Leitfähigkeitsmessung möglich.

Als günstigste Wahl für die Frequenzmeßeinrichtung im Rahmen der Vorrichtung nach der Erfindung stellt sich ein Frequenzzähler dar, da die mit einem Frequenzzähler erzielbare Meßgenauigkeit extrem hoch liegt, so daß die Messung der Frequenz zu dem Meßfehler für die elektrische Leitfähigkeit praktisch nicht mehr beiträgt.

Wie bereits erwähnt, empfiehlt sich bei der Wahl des Frequenzbereiches für die Resonanzfrequenz des Parallelschwingkreises der Bereich zwischen 1 MHz und 20 MHz, insbesondere der Bereich zwischen 2 MHz und 10 MHz.

In vorteilhafter Weiterbildung der erfindungsgemäßen Vorrichtung jedweder Gestaltung weist die Spulenanordnung mindestens eine Spule mit einem Innenbereich auf, in den der Probenkörper einbringbar ist. Im Innenbereich einer Spule ist das durch die Spule erzeugbare Magnetfeld besonders groß, so daß sich eine besonders hohe Beeinflussung der Eigenschaften der Spulenanordnung durch einen in den Innenbereich eingebrachten Probenkörper ergibt. Die Spulenanordnung kann dabei aus einer einzelnen, etwa prismatischen oder etwa zylindrischen Spule bestehen; eine solche Spule erzeugt außerdem in ihrem Innenbereich ein weitgehend homogenes Magnetfeld, so daß sich zusätzliche Vorteile dadurch ergeben, daß die Positionierung des Probenkörpers in der Spule relativ unkritisch ist. Eine gleichermaßen vorteilhafte Spulenanordnung ist ein Helmholtz-Spulenpaar aus zwei relativ flachen, koaxial gewickelten Spulen, die in einem gewissen Abstand voneinander angeordnet sind. Zwischen den beiden Spulen gibt es ebenfalls einen Bereich, in dem das Magnetfeld weitgehend homogen ist, und dieser Bereich ist, bedingt durch die relativ "offene" Spulenanordnung, sehr gut erreichbar. Dies ist besonders wichtig in dem Fall, in dem der Probenkörper von der Umwelt abgeschirmt werden muß, beispielsweise zum Zwecke der thermischen Isolierung.

Eine alternative Ausgestaltung der Spulenanordnung im Rahmen der erfindungsgemäßen Vorrichtung ist gegeben durch die Verwendung einer etwa ebenen Schleife als Spule in dem Parallelschwingkreis. Durch die Verwendung einer solchen Schleife wird eine Vorrichtung erzielt, mit der beispielsweise größere Oberflächen abtastbar und auf ihre elektrische Leitfähigkeit hin untersuchbar sind, indem die Schleife über die Oberflächen hinwegbewegt wird.

Im Hinblick auf das bevorzugte Anwendungsgebiet der Erfindung empfiehlt es sich, die Vorrichtung gemäß der Erfindung in jedweder Ausführung mit einer Temperiereinrichtung, insbesondere einer Kühleinrichtung, zur Halterung und Temperierung des Probenkörpers auf eine vorgebbare Temperatur sowie einer Abschirmeinrichtung zur thermischen Isolierung des Probenkörpers zu versehen. Die Sprungtemperaturen der bekannten supraleitfähigen Materialien liegen in dem Temperaturbereich unterhalb von 100 K; zur Temperierung, insbesondere zur sorgfältig kontrollierten Temperierung, eines Probenkörpers sind daher neben angemessenen Kühleinrichtungen auch entsprechend ausgelegte Abschirmeinrichtungen, darunter in der Regel Vakuum-Abschirmungen, unerläßlich.

Die weitere Erläuterung der Erfindung erfolgt anhand der in der Zeichnung dargestellten Ausführungsbeispiele; im einzelnen zeigen:
Figur 1 eine Anordnung mit Probenkörper und Parallelschwingkreis sowie einer Kühleinrichtung;
Figur 2 ein als Spulenanordnung geeignetes Helmholtz-Spulenpaar mit einem Probenkörper;
Figur 3 eine Spulenanordnung zur Untersuchung einer ausgedehnten Fläche eines Probenkörpers;
Figur 4 typische Ergebnisse einer Messung unter Benutzung der Erfindung;
Figur 5 eine teilweise schematisierte Schaltungsanordnung für eine Vorrichtung nach der Erfindung.

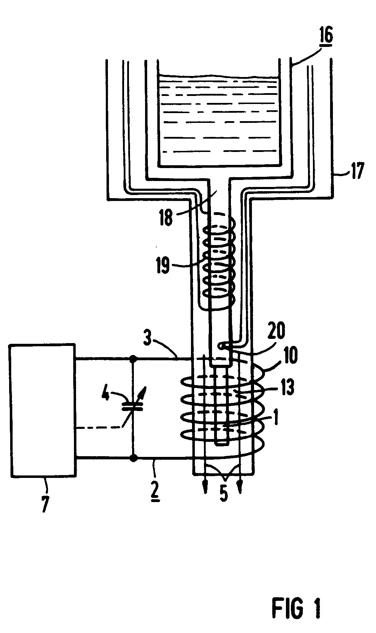

Figur 1 zeigt einen Probenkörper 1 aus supraleitfähigem Material, der im Innenbereich 13 einer Spule 10 angeordnet ist, wobei die Spule 10 wesentliches Bestandteil der Spulenanordnung 3 eines Parallelschwingkreises 2 ist. Neben der Spulenanordnung 3 besteht der Parallelschwingkreis 2 aus der Kondensatoranordnung 4, im vorliegenden Fall einem mechanisch oder elektrisch abstimmbaren Kondensator. Der Parallelschwingkreis 2 ist angeschlossen an einen Generator 7, in dem im dargestellten Fall alle Einrichtungen zur Durchführung des erfindungsgemäßen Verfahrens einbezogen sein sollen. In der Spule 10 wird ein Magnetfeld 5 - angedeutet durch Pfeile - erzeugt, das den Probenkörper 1 durchsetzt. In dem Probenkörper 1 werden dadurch Wirbelströme hervorgerufen, die die Induktivität der Spule 10 beeinflussen und durch Bestimmung der Parameter der Spule 10 nach der Erfindung ausmeßbar sind. Der Probenkörper 1 befindet sich am Kühlfinger 18 einer Temperiereinrichtung 16, die im vorliegenden Fall im wesentlichen aus einem Gefäß besteht, das ein Kühlmittel wie z. B. flüssigen Stickstoff enthält und an dem der Kühlfinger 18 angeschlossen ist. Auf dem Kühlfinger 18 befindet sich, zwischen dem Gefäß und dem Probenkörper 1, eine Heizeinrichtung 19 in Gestalt einer elektrisch betreibbaren Heizleiterwicklung, die eine gewisse Variation der Temperatur des Probenkörpers 1 erlaubt. Zur Bestimmung der Temperatur des Probenkörpers 1 ist der Kühlfinger 18 darüber hinaus mit einem Temperaturfühler 20, beispielsweise einem Thermoelement, versehen. Die Temperiereinrichtung 16 und der Probenkörper 1 sind umgeben von einer Abschirmeinrichtung 17, insbesondere einem Vakuumgefäß, das den Probenkörper 1 und die Temperiereinrichtung 16 von der Umgebung isoliert.

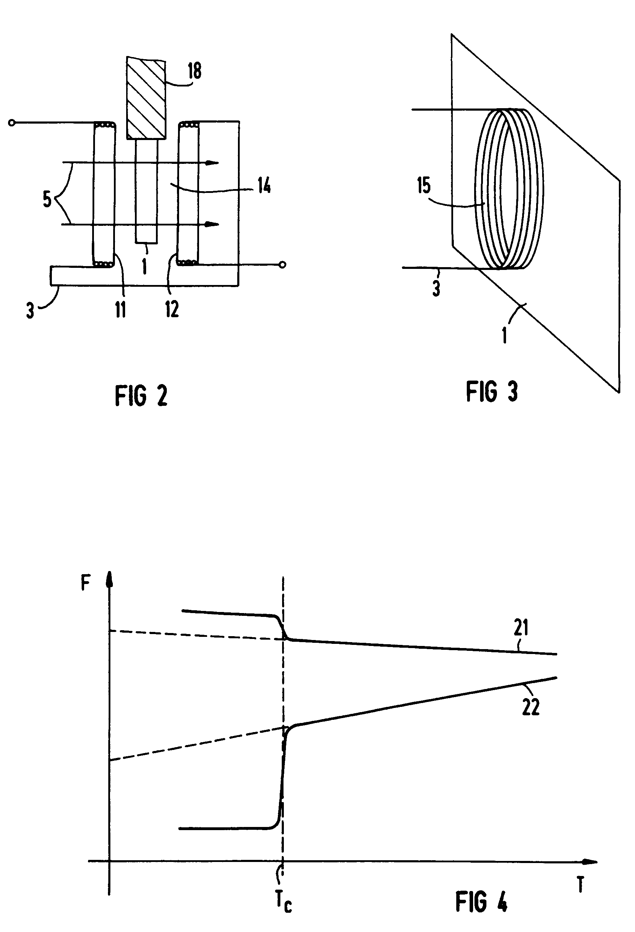

In den Figuren 2 und 3 der Zeichnung sind weitere Ausführungsbeispiele für die Spulenanordnung 3 dargestellt. Figur 2 zeigt ein Helmnoltz-Spulenpaar aus einer ersten Spule 11 und einer zweiten Spule 12, die elektrisch in Reihe geschaltet und koaxial unter Wahrung eines gewissen Abstandes voneinander angeordnet sind. Im Innenbereich 14 zwischen den Spulen 11, 12 befindet sich der Probenkörper 1, wiederum an einem Kühlfinger 18 bzw. einer anderen Halteeinrichtung. Figur 3 zeigt eine Spulenanordnung 3 mit einer ebenen, flachen Schleife 15, die zur Inspektion eines flächenhaften Probenkörpers 1 gut geeignet ist, wobei durch geeignete Führungseinrichtungen für die Schleife 15 oder den Probenkörper 1 eine relative Bewegung beider zueinander ermöglicht werden kann.

Figur 4 zeigt typische Meßwerte, wie sie mit dem erfindungsgemäßen Verfahren erzielbar sind. Auf der Abszisse aufgetragen ist die Temperatur T des Probenkörpers, auf der Ordinate liegt die gemessene Resonanzfrequenz F des Parallelschwingkreises. Der erste Graph 21 stellt ein Meßresultat dar, das mit dem Meßverfahren gemäß dem Stand der Technik erzielt wurde. Oberhalb der kritischen Temperatur T_{c} des Probenkörpers ist die Resonanzfrequenz des Parallelschwingkreises fast konstant; die auftretenden Frequenzänderungen werden nicht nur durch Änderung der elektrischen Verhältnisse in dem Probenkörper bedingt, sondern auch durch Temperatureinflüsse auf den Parallelschwingkreis selbst, z. B. thermisch bedingte Größenänderungen der Induktivität, Verschiebungen des Probenkörpers innerhalb der Spulenanordnung aufgrund thermischer Dehnungen, Schrumpfungen der Halteeinrichtungen oder dergleichen. Entsprechend muß eine Meßvorrichtung vor der Durchführung einer Leitfähigkeitsmessung sorgfältig ohne einen Probenkörper ausgemessen werden, um Effekte aufgrund des Vorhandenseins des Probenkörpers von apparativ bedingten Effekten trennen zu können. Bei Erreichen der Sprungtemperatur T_{C} des Probenkörpers findet eine deutliche Veränderung der Resonanzfrequenz des Parallelschwingkreises, wie erwartet hin zu höheren Frequenzen, statt. Dieser Sprung in der Resonanzfrequenz wird unmittelbar verursacht durch die einsetzende Supraleitfähigkeit, die ein beträchtliches Ansteigen der Wirbelströme in dem Probenkörper zuläßt. Der zweite Graph 22 in Figur 4 stellt das Resultat einer Messung gemäß der Erfindung dar. Einer relativ geringen Frequenzänderung im Temperaturbereich oberhalb der Sprungtemperatur T_{C}, die immerhin deutlich stärker ausfällt als die Frequenzänderung im Fall der Messung nach dem Stand der Technik, folgt eine sprunghafte Verringerung der Resonanzfrequenz auf etwa 25 % ihres Wertes bei Unterschreiten der Sprungtemperatur. Die hohe Empfindlichkeit der erfindungsgemäßen Meßmethode wird damit deutlich; wie bereits erwähnt, ist sie darin begründet, daß ein Parameter gemessen wird, der der die Supraleitfähigkeit bestimmenden Größe unmittelbar umgekehrt proportional ist und dessen Abhängigkeit von dieser Größe auch dann noch gegeben ist, wenn diese Null wird.

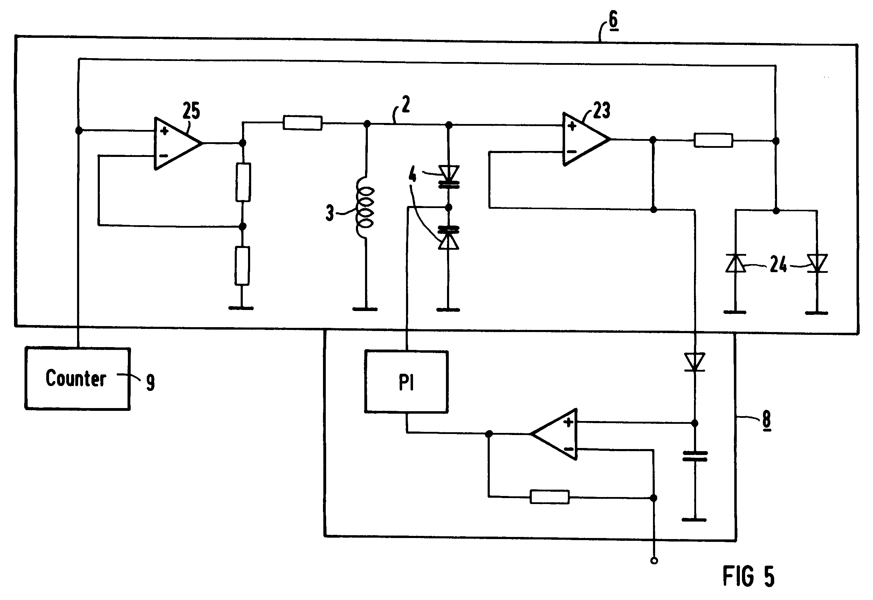

Figur 5 zeigt einen Vorschlag, wie zur Realisierung der Erfindung der Parallelschwingkreis 2 aus Spulenanordnung 3 und Kondensatoranordnung 4 beschaltet werden könnte. Die Spulenanordnung 3 ist nur schematisch dargestellt; in der Praxis ist eine Spule oder eine Anordnung von Spulen dem jeweiligen Anwendungsfall entsprechend auszuwählen. Als Kondensatoranordnung 4 werden zwei antiparallel geschaltete Kapazitätsdioden eingesetzt, die einen Kondensator bilden, dessen Kapazität durch Anlegen einer elektrischen Gleichspannung veränderbar ist. Der Schwingkreis 2 ist eingebunden in einen Oszillator 6, der so ausgelegt ist, daß die in dem Parallelschwingkreis 2 zu erzeugende elektronische Schwingung weitgehend unbeeinflußt von Übersteuerungserscheinungen, wie sie zur Amplitudenbegrenzung in jedem Oszillator 6 notwendig sind, bleiben kann. Der Oszillator 6 ist aufgebaut mit Operationsverstärkern, was für die praktische Anwendung nur dann machbar ist, wenn die Resonanzfrequenz des Parallelschwingkreises 2 ausreichend niedrig ist. Jedoch können die Operationsverstärker durchaus durch aktive elektronische Elemente ersetzt werden, die auch bei hohen Frequenzen sicher funktionieren, beispielsweise Anordnungen mit Feldeffekttransistoren oder dergleichen. Die über dem Parallelschwingkreis 2 liegende Wechselspannung wird dem Eingang eines Spannungsfolgers 23 zugeführt, an dessen Ausgang eine Wechselspannung gleicher Amplitude entsteht, die ohne Beeinflussung des Parallelschwingkreises 2 weiteren Teilen der Schaltung zugeführt werden kann. Sie gelangt auf den Eingang eines Treibers 25, der aus einem als Elektrometerverstärker beschalteten Operationsverstärker besteht und einen Wechselstrom erzeugt, mit dem der Parallelschwingkreis 2 zu beaufschlagen ist. Zwischen dem Ausgang des Spannungsfolgers 23 und dem Eingang des Treibers 25 befindet sich ein Begrenzer 24 aus zwei antiparallel geschalteten Dioden, der die am Eingang des Treibers 25 liegende Wechselspannung unabhängig von ihrer Polarität auf ein Maximum entsprechend der über jeder der Dioden des Begrenzers 24 liegenden Durchlaßspannung begrenzt.

Damit wird auch eine Begrenzung des aus dem Treiber 25 in den Parallelschwingkreis 2 fließenden Wechselstromes erreicht; die Abhängigkeit der Amplitude des von dem Treiber 25 lieferbaren Stromes von der am Eingang des Spannungsfolgers 23 liegenden Spannung ist so zu bemessen, daß beim regulären Betrieb 25 der maximal mögliche Strom geliefert wird. Die erfindungsgemäße Abstimmung des Parallelschwingkreises 2 zur Stabilisierung des Resonanzwiderstandes auf einen vorzugebenden Wert erfolgt mittels einer Regeleinrichtung 8. Diese Regeleinrichtung 8 enthält zunächst einen Gleichrichter, der mit dem Ausgang des Spannungsfolgers 23 verbunden ist und mit dem die Amplitude der über dem Parallelschwingkreis 2 liegenden Wechselspannung bestimmbar ist. Die mit dem Gleichrichter erhaltene Spannung wird einem Operationsverstärker zugeführt, der die Differenz aus dem Meßwert für die Amplitude und dem vorgebbaren Sollwert bildet. Die Vorgabe des Sollwertes erfolgt durch Beaufschlagung des entsprechenden Einganges des genannten Operationsverstärkers mit einem dem Sollwert entsprechenden Gleichstrom. Am Ausgang des Operationsverstärkers ist schließlich ein Netzwerk angeordnet, das die Funktionen eines PI-Reglers hat und das die Gleichspannung liefert, mit der zur Abstimmung der Resonanzfrequenz des Parallelschwingkreises 2 die Kapazität der Kondensatoranordnung 4 verändert wird. Schließlich ist an den Oszillator 6 noch eine Frequenzmeßeinrichtung 9, namentlich ein Frequenzzähler, angeschlossen. Die Anordnung aus Oszillator 6 und Regeleinrichtung 8 arbeitet weitgehend automatisch, so daß die zur Anwendung des Verfahrens notwendigen Verrichtungen lediglich in der Einbringung des Probenkörpers in die Spulenanordnung 3, der Einstellung der Temperatur des Probenkörpers und der Entnahme des Meßwertes aus der Frequenzmeßeinrichtung bestehen.

Die Erfindung betrifft ein Verfahren und eine Vorrichtung zur Bestimmung der elektrischen Leitfähigkeit eines Probenkörpers aus supraleitfähigem Material, wobei im Vergleich zum Stand der Technik eine wesentliche Steigerung der Empfindlichkeit erzielbar ist und quantitative Aussagen über den Verlauf der Leitfähigkeit im Temperaturbereich in der Nähe der Sprungtemperatur ermöglicht werden.

## Patentansprüche

1. Verfahren zur Bestimmung der elektrischen Leitfähigkeit eines Probenkörpers (1) aus supraleitfähigem Material, unter Benutzung eines Parallelschwingkreises (2) aus einer Spulenanordnung (3) mit einer Induktivität und einer Kondensatoranordnung (4) mit einer Kapazität, wobei der Parallelschwingkreis (2) eine durch Variation der Induktivität und/oder Variation der Kapazität abstimmbare Resonanzfrequenz sowie einen Resonanzwiderstand aufweist, unter Einbeziehung folgender Schritte:
a) Annähern des Probenkörpers (1) an die Spulenanordnung (3), so daß der Probenkörper (1) von einem in der Spulenanordnung (3) erzeugten Magnetfeld (5) durchsetzbar ist;
b) Ermittlung der elektrischen Leitfähigkeit durch Messung der Resonanzfrequenz;
**gekennzeichnet durch**
c) Messung des Resonanzwiderstandes zusätzlich zur Messung der Resonanzfrequenz sowie Abstimmung der Resonanzfrequenz derart, daß der Resonanzwiderstand gleich einem vorgebbaren Sollwert wird;
d) Ermittlung der elektrischen Leitfähigkeit unter der Bedingung, daß der Resonanzwiderstand gleich dem Sollwert ist.

2. Verfahren nach Anspruch 1, wobei der Parallelschwingkreis (2) Bestandteil eines Oszillators (6) ist, in dem zumindest zur Messung der Resonanzfrequenz eine elektronische Schwingung erzeugt wird, die charakterisiert ist durch eine über dem Parallelschwingkreis (2) liegende Wechselspannung mit einer Spannungsamplitude und einen dem Parallelschwingkreis (2) zugeführten Wechselstrom mit einer Stromamplitude.

3. Verfahren nach Anspruch 2, wobei die Spannungsamplitude auf einem vorgegebenen Wert gehalten und zur Messung des Resonanzwiderstandes die Stromamplitude bestimmt wird.

4. Verfahren nach Anspruch 2, wobei die Stromamplitude auf einem vorgegebenen Wert gehalten und zur Messung des Resonanzwiderstandes die Spannungsamplitude bestimmt wird.

5. Verfahren nach einem der vorhergehenden Ansprüche, wobei die Induktivität und die Kapazität so bemessen sind, daß die Resonanzfrequenz etwa in dem Bereich zwischen 1 MHz und 20 MHz, insbesondere etwa in dem Bereich zwischen 2 MHz und 10 MHz, liegt.

6. Verfahren nach einem der vorhergehenden Ansprüche, wobei das supraleitfähige Material eine Sprungtemperatur hat und die Temperaturabhängigkeit der elektrischen Leitfähigkeit im Bereich der Sprungtemperatur bestimmt wird, derart, daß der Probenkörper (1) mehrmals jeweils auf eine Temperatur im Bereich der Sprungtemperatur gebracht und die Resonanzfrequenz unter Beibehaltung eines vorgegebenen Wertes für den Resonanzwiderstand gemessen wird.

7. Vorrichtung zur Bestimmung der elektrischen Leitfähigkeit eines Probenkörpers (1) aus supraleitfähigem Material, die folgende Bestandteile aufweist:
a) eine Spulenanordnung (3) mit einer Induktivität, durch welche Spulenanordnung (3) ein Magnetfeld (5) erzeugbar ist, in das der Probenkörper (1) einbringbar ist;
b) mindestens eine Kondensatoranordnung (4) mit einer Kapazität, welche Kondensatoranordnung (4) mit der Spulenanordnung (3) zu einem Parallelschwingkreis (2) mit einer Resonanzfrequenz und einem Resonanzwiderstand verschaltet ist, welche Resonanzfrequenz durch Variation der Induktivität und/oder Variation der Kapazität abstimmbar ist;
c) einen Generator (7), durch den in dem Parallelschwingkreis (2) eine elektronische Schwingung mit der Resonanzfrequenz erregbar ist, welche Schwingung charakterisiert ist durch eine über dem Parallelschwingkreis (2) liegende Wechselspannung mit einer Spannungsamplitude und einen dem Parallelschwingkreis (2) zugeführten Wechselstrom mit einer Stromamplitude;
d) eine Frequenzmeßeinrichtung (9), mit der die Resonanzfrequenz meßbar ist;
**gekennzeichnet durch**
e) eine Regeleinrichtung (8), mit der der Resonanzwiderstand meßbar und die Resonanzfrequenz abstimmbar sowie die Resonanzfrequenz mit dem Resonanzwiderstand und einem vorgebbaren Sollwert für den Resonanzwiderstand derart korrelierbar ist, daß bei einer Abweichung des Resonanzwiderstandes von dem Sollwert durch Abstimmung der Resonanzfrequenz eine Übereinstimmung des Resonanzwiderstandes mit dem Sollwert erzielbar ist.

8. Vorrichtung nach Anspruch 7, wobei der Generator (7) mit dem Parallelschwingkreis (2) zu einem Oszillator (6) verschaltet ist.

9. Vorrichtung nach Anspruch 8, wobei der Oszillator (6) einen negativen ohmschen Widerstand aufweist, der dem Parallelschwingkreis (2) parallel geschaltet ist und einen Betrag hat, der mit einer über dem Parallelschwingkreis (2) liegenden Wechselspannung monoton wächst und ein Minimum hat, das einstellbar ist.

10. Vorrichtung nach einem der Ansprüche 7 bis 9, wobei die Frequenzmeßeinrichtung (9) ein Frequenzzähler ist.

11. Vorrichtung nach einem der Ansprüche 7 bis 10, wobei die Induktivität und die Kapazität so bemessen sind, daß die Resonanzfrequenz etwa in dem Bereich zwischen 1 MHz und 20 MHz, insbesondere etwa in dem Bereich zwischen 2 MHz und 10 MHz, liegt.

12. Vorrichtung nach einem der Ansprüche 7 bis 11, wobei die Spulenanordnung (3) mindestens eine Spule (10; 11; 12) mit einem Innenbereich (13; 14), in den der Probenkörper (1) einbringbar ist, aufweist.

13. Vorrichtung nach Anspruch 12, wobei die Spulenanordnung (3) eine einzelne Spule (10) von etwa prismatischer, insbesondere etwa zylindrischer Form mit einem Innenbereich (13) aufweist.

14. Vorrichtung nach Anspruch 12, wobei die Spulenanordnung (3) gebildet ist mit einer ersten Spule (11) und einer zweiten Spule (12), die als Helmholtz-Spulenpaar angeordnet sind, wobei der Innenbereich (14) zwischen der ersten Spule (11) und der zweiten Spule (12) liegt.

15. Vorrichtung nach einem der Ansprüche 7 bis 11, wobei die Spulenanordnung (3) eine etwa ebene Schleife (15) aufweist, an die der Probenkörper (1) annäherbar ist.

16. Vorrichtung nach einem der Ansprüche 7 bis 15 mit einer Temperiereinrichtung (16), insbesondere einer Kühleinrichtung, zur Temperierung des Probenkörpers (1) auf eine vorgebbare Temperatur sowie eine Abschirmeinrichtung (17) zur thermischen Isolierung des Probenkörpers (1).

## Claims

1. Process for determining the electrical conductivity of a test specimen (1) of superconducting material using a parallel resonant circuit (2) consisting of a coil arrangement (3) with an inductance and a capacitor arrangement (4) with a capacitance, the parallel resonant circuit (2) having a resonance frequency which can be tuned by varying the inductance and/or by varying the capacitance, as well as a resonant resistance, comprising the following steps:
a) moving the test specimen (1) near to the coil arrangement (3) such that the test specimen (1) can be penetrated by a magnetic field (5) generated in the coil arrangement (3); and
b) determining the electrical conductivity by measuring the resonance frequency;
characterized by:
c) measuring the resonant resistance in addition to measuring the resonance frequency and tuning the resonance frequency in such a way that the resonant resistance becomes equal to a predeterminable nominal value; and
d) determining the electrical conductivity on the condition that the resonant resistance is equal to the nominal value.

2. Process according to Claim 1, in which the parallel resonant circuit (2) is a component of an oscillator (6) in which an electronic oscillation is generated at least for measuring the resonance frequency, which oscillation is characterised by an alternating voltage, with a voltage amplitude, across the parallel resonant circuit (2) and an alternating current, with a current amplitude, delivered to the parallel resonant circuit (2).

3. Process according to Claim 2, in which the voltage amplitude is maintained at a predetermined value and the current amplitude is determined in order to measure the resonant resistance.

4. Process according to Claim 2, in which the current amplitude is maintained at a predetermined value and the voltage amplitude is determined in order to measure the resonant resistance.

5. Process according to any one of the preceding claims, in which the inductance and the capacitance are dimensioned in such a way that the resonance frequency is approximately in the range of between 1 MHz and 20 MHz, in particular approximately in the range of between 2 MHz and 10 MHz.

6. Process according to any one of the preceding claims, in which the superconducting material has a transition temperature and the temperature dependence of the electrical conductivity is determined in the vicinity of the transition temperature in such a way that the test specimen (1) is brought several times in each case to a temperature in the vicinity of the transition temperature and the resonance frequency is measured while maintaining a predetermined value for the resonant resistance.

7. Device for determining the electrical conductivity of a test specimen (1) of superconducting material, comprising the following components:
a) a coil arrangement (3) having an inductance, which coil arrangement (3) can generate a magnetic field (5) into which the test specimen (1) can be introduced;
b) at least one capacitor arrangement (4) having a capacitance, which capacitor arrangement (4) is connected to the coil arrangement (3) to form a parallel resonant circuit (2) having a resonance frequency and a resonant resistance, which resonance frequency can be tuned by varying the inductance and/or by varying the capacitance;
c) a generator (7) which can excite an electronic oscillation at the resonance frequency in the parallel resonant circuit (2), which oscillation is characterized by an alternating voltage, having a voltage amplitude, across the parallel resonant circuit (2) and an alternating current, having a current amplitude, delivered to the parallel resonant circuit (2); and
d) a frequency measuring device (9) which can measure the resonance frequency (9);
characterized by:
e) a control device (8) which can measure the resonant resistance, can tune the resonance frequency, and can correlate the resonance frequency with the resonant resistance and a predeterminable nominal value for the resonant resistance such that, when the resonant resistance differs from the nominal value, the resonant resistance can be made to correspond to the nominal value by tuning the resonance frequency.

8. Device according to Claim 7, in which the generator (7) is connected to the parallel resonant circuit (2) to form an oscillator (6).

9. Device according to Claim 8, in which the oscillator (6) comprises a negative ohmic resistance which is connected parallel to the parallel resonant circuit (2) and has an amount which increases monotonically with an alternating voltage across the parallel resonant circuit (2) and has a minimum which is adjustable.

10. Device according to any one of Claims 7 to 9, in which the frequency measuring device (9) is a frequency counter.

11. Device according to any one of Claims 7 to 10, in which the inductance and the capacitance are dimensioned such that the resonance frequency is approximately in the range of between 1 MHz and 20 MHz, in particular approximately in the range of between 2 MHz and 10 MHz.

12. Device according to any one of Claims 7 to 11, in which the coil arrangement (3) comprises at least one coil (10; 11; 12) having an inner region (13; 14) into which the test specimen (1) can be introduced.

13. Device according to Claim 12, in which the coil arrangement (3) comprises a single coil (10) of approximately prismatic, in particular approximately cylindrical, shape with an inner region (13).

14. Device according to Claim 12, in which the coil arrangement (3) is formed with a first coil (11) and a second coil (12) which are disposed as a pair of Helmholtz coils, the inner region (14) lying between the first coil (11) and the second coil (12).

15. Device according to any one of Claims 7 to 11, in which the coil arrangement (3) comprises an approximately flat loop (15) which can be approached by the test specimen (1).

16. Device according to any one of Claims 7 to 15 with a tempering device (16), in particular a cooling device, for tempering the test specimen (1) to a predeterminable temperature and a shielding device (17) for thermally insulating the test specimen (1).

## Revendications

1. Procédé pour déterminer la conductivité électrique d'une éprouvette (1) réalisée en un matériau supraconducteur, moyennant l'utilisation d'un circuit oscillant parallèle (2) constitué par un dispositif à bobines (3) présentant une inductance et par un dispositif à condensateur (4) possédant une capacité, le circuit oscillant parallèle (2) possédant une fréquence de résonance qui peut être accordée moyennant une modification de l'inductance et/ou une modification de la capacité, ainsi qu'une résistance de résonance, moyennant la mise en oeuvre des étapes suivantes :
a) rapprochement de l'éprouvette (1) vers le dispositif à bobines (3) de façon que l'éprouvette (1) puisse être traversée par un champ magnétique (5) produit dans le dispositif à bobines (3);
b) détermination de la conductivité électrique par mesure de la fréquence de résonance;
caractérisé par
c) une mesure de la résistance de résonance en plus de la mesure de la fréquence de résonance et un réglage d'accord de la fréquence de résonance de manière que la résistance de résonance soit égale à une valeur de consigne pouvant être prédéterminée;
d) une détermination de la conductivité électrique à la condition que la résistance de résonance soit égale à la valeur de consigne.

2. Procédé selon la revendication 1, selon lequel le circuit oscillant parallèle (2) fait partie d'un oscillateur (6) dans lequel, au moins pour la mesure de la fréquence de résonance, est produite une oscillation électronique qui est caractérisée par une tension alternative, appliquée par l'intermédiaire du circuit oscillant parallèle et possédant une amplitude de tension, et un courant alternatif envoyé au circuit oscillant parallèle (2) et possédant une amplitude de courant.

3. Procédé selon la revendication 2, selon lequel l'amplitude de tension est maintenue à une valeur prédéterminée et l'amplitude de courant est déterminée pour la mesure de la résistance de résonance.

4. Procédé selon la revendication 2, selon lequel l'amplitude du courant est maintenue à une valeur prédéterminée, et l'amplitude de tension est déterminée pour la mesure de la résistance de résonance.

5. Procédé selon l'une des revendications précédentes, selon lequel l'inductance et la capacité sont dimensionnées de telle sorte que la fréquence de résonance se situe approximativement dans la gamme comprise entre 1 MHz et 20 MHz, notamment approximativement dans la gamme comprise entre 2 MHz et 10 MHz.

6. Procédé selon l'une des revendications précédentes, selon lequel le matériau supraconducteur possède une température de transition et que la dépendance de la conductivité électrique vis-à-vis de la température au voisinage de la température de transition est déterminée de telle sorte que l'éprouvette (1) est amenée à plusieurs reprises respectivement à une température située au voisinage de la température de transition et que la fréquence de résonance est mesurée moyennant le maintien d'une valeur prédéterminée pour la résistance de résonance.

7. Dispositif pour déterminer la conductivité électrique d'une éprouvette (1) réalisée en un matériau supraconducteur, et comportant les composants suivants :
a) un dispositif à bobines (3) possédant une inductance et au moyen duquel peut être produit un champ magnétique (5), dans lequel l'éprouvette (1) est susceptible d'être placée;
b) au moins un dispositif à condensateur(s) (4) possédant une capacité et qui est connectée au dispositif à bobine(s) (30) pour former un circuit oscillant parallèle (2) possédant une fréquence de résonance et une résistance de résonance, la fréquence de résonance pouvant être accordée par modification de l'inductance et/ou par modification de la capacité;
c) un générateur (7), grâce auquel une oscillation électronique possédant la fréquence de résonance peut être excitée dans le circuit oscillant parallèle (2), cette oscillation étant caractérisée par une tension alternative appliquée par l'intermédiaire du circuit oscillant parallèle (2) et possédant une amplitude de tension, et par un courant alternatif envoyé au circuit oscillant parallèle (2) et possédant une amplitude de courant;
d) un dispositif de mesure de fréquence (9), au moyen duquel la fréquence de résonance peut être mesurée;
caractérisé par
e) un dispositif de régulation (8), au moyen duquel la résistance de résonance peut être mesurée et la fréquence de résonance peut être accordée, et la fréquence de résonance peut être mise en corrélation avec la résistance de résonance et avec une valeur de consigne pouvant être prédéterminée pour la résistance de résonance, de telle sorte que, dans le cas d'un écart entre la résistance de résonance et la valeur de consigne, on peut obtenir, en accordant la fréquence de résonance, une résistance de résonance égale à la valeur de consigne.

8. Dispositif suivant la revendication 7, dans- lequel le générateur (7) équipé du circuit oscillant parallèle (2) est raccordé à un oscillateur (6).

9. Dispositif selon la revendication 8, dans lequel l'oscillateur (6) possède une résistance ohmique négative, qui est branchée en parallèle avec le circuit oscillant parallèle (2) et possède une valeur absolue qui augmente d'une manière monotone avec une tension alternative appliquée au circuit oscillant parallèle (2) et possède un minimum qui est réglable.

10. Dispositif suivant l'une des revendications 7 à 9, dans lequel le dispositif (9) de mesure de la fréquence est un compteur de fréquences.

11. Dispositif suivant l'une des revendications 7 à 10, dans lequel l'inductance et la capacité sont dimensionnées de telle sorte que la fréquence de résonance est située approximativement dans la gamme comprise entre 1 MHz et 20 MHz, notamment approximativement dans la gamme comprise entre 2 MHz et 10 MHz.

12. Dispositif suivant l'une des revendications 7 à 11, dans lequel le dispositif à bobines (3) possède au moins une bobine (10; 11; 12) comportant une zone intérieure (13; 14), dans laquelle l'éprouvette (1) peut être introduite.

13. Dispositif suivant la revendication 12, dans lequel le dispositif à bobines (3) possède une seule bobine (10) de forme approximativement prismatique et notamment approximativement cylindrique, présentant une zone intérieure (13).

14. Dispositif suivant la revendication 12, dans lequel le dispositif à bobines (3) est formé par une première bobine (11) et par une seconde bobine (12), qui sont disposées sous la forme d'un couple de bobines de Helmholtz, la zone intérieure (14) étant située entre la première bobine (11) et la seconde bobine (12).

15. Dispositif suivant l'une des revendications 7 à 11, dans lequel le dispositif à bobines (3) possède une boucle approximativement plane (15), vers laquelle peut être rapprochée l'éprouvette (1).

16. Dispositif suivant l'une des revendications 7 à 15 comportant un dispositif de mise en température (16), notamment un dispositif de refroidissement, pour le réglage de l'éprouvette (1) à une température pouvant être prédéterminée, ainsi qu'un dispositif de blindage (17) servant à réaliser l'isolation thermique de l'éprouvette (1).
